## Europäisches Patentamt
## European Patent Office
## Office européen des brevets

(11) Veröffentlichungsnummer: **0 104 304**
**B1**

(12) # EUROPÄISCHE PATENTSCHRIFT

(45) Veröffentlichungstag der Patentschrift:
**26.11.86**

(51) Int. Cl.⁴: **H 05 K 11/02**

(21) Anmeldenummer: **83101600.1**

(22) Anmeldetag: **19.02.83**

(54) **Autoradio.**

(30) Priorität: **27.08.82 DE 3231952**

(43) Veröffentlichungstag der Anmeldung:
**04.04.84 Patentblatt 84/14**

(45) Bekanntmachung des Hinweises auf die Patenterteilung:
**26.11.86 Patentblatt 86/48**

(84) Benannte Vertragsstaaten:
**AT BE CH DE FR GB IT LI LU NL SE**

(56) Entgegenhaltungen:
**CH-A-422 051**
**DE-A-1 958 993**
**DE-B-1 302 591**
**US-A-2 832 013**
**US-A-4 048 669**

(73) Patentinhaber: **Röhlich, Manfred, Dipl.- Kfm.,
Felkestrasse 51, D-4600 Dortmund 1 (DE)**
Patentinhaber: **Krebs, Dieter, Auf'm Plätzchen 31,
D-4600 Dortmund 1 (DE)**

(72) Erfinder: **Röhlich, Manfred, Dipl.- Kfm.,
Felkestrasse 51, D-4600 Dortmund 1 (DE)**
Erfinder: **Krebs, Dieter, Auf'm Plätzchen 31, D-4600
Dortmund 1 (DE)**

(74) Vertreter: **Lorenz, Werner, Dipl.- Ing.,
Fasanenstrasse 7, D-7920 Heidenheim (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Autoradio mit einem Gehäuse, mehreren auf einer Frontplatte des Gehäuses angeordneten Bedienungselementen und Anzeigelementen und mehreren in dem Gehäuse angeordneten Platinen, wobei auf den Platinen jeweils mehrere elektrische und/oder elektronische Bauelemente angeordnet sind und wobei elektrische und/oder elektronische Bauelemente auf verschiedene Platinen elektrisch miteinander verbunden sind.

Bei den bislang verbreiteten, den Anmeldern aus der Praxis bekannten Autoradios sind häufig Platinen vorgesehen, auf denen die benötigten elektrischen und/oder elektronischen Bauelemente angeordnet sind. Diese Platinen sind mit dem Gehäuse über Schraubsockel verbunden und tragen jeweils mehr oder weniger ungeordnet eine bestimmte Anzahl und Auswahl von elektrischen und/oder elektronischen Bauelementen. Die elektrischen Verbindungen zwischen elektrischen und/oder elektronischen Bauelementen verschiedener Platinen werden über elektrische Leitungen hergestellt, die mit den einzelnen Bauelementen verlötet werden. Im übrigen wird mitunter auch nur eine einzige großflächige Platine verwendet, auf der alle oder praktisch alle benötigten elektrischen und/oder elektronischen Bauelemente angeordnet sind. In jedem Fall ist die Beseitigung von Störungen bei den bekannten Autoradios problematisch. Einerseits erfordert jede Reparaturmaßnahme an einem Autoradio einen vollständigen Ausbau des Autoradios, andererseits erfordert das Auffinden der Störung in den bekannten Autoradios einen erheblichen Aufwand, insbesondere eine erhebliche Zeit und schließlich führt die Tatsache, daß zumeist dem Kunden ein Ersatzgerät mitgegeben wird dazu, daß die Reparaturwerkstätten sich mit der Beseitigung der Störungen besonders viel Zeit lassen. Insgesamt ist also der mit der Beseitigung von Störungen bei bekannten Autoradios verbundene Gesamtaufwand, d. h. der Aufwand an Reparaturkosten, an Arbeitszeit für die Reparatur und an von dem entsprechenden Kunden aufzubringender Zeit relativ hoch.

Aus der Fernsehtechnik ist es seit längerem bekannt (vgl. die CH-A- 422 051), die elektrischen und/oder elektronischen Bauelemente für jeweils eine Funktionseinheit in jeweils einem steckbaren Modul zusammenzufassen. Die Moduln weisen an einer Seite Kontaktleisten auf. Im Gehäuse eines entsprechenden Fernsehgeräts sind Einsteckfassungen für die Kontaktleisten der Moduln vorgesehen, so daß durch Einstecken die Moduln mechanisch mit dem Gehäuse und damit miteinander und die elektrischen und/oder elektronischen Bauelemente verschiedener Moduln elektrisch miteinander verbindbar sind. Der Aufbau eines solchen Fernsehgerätes ist leicht überschaubar und es besteht die Möglichkeit, jede Funktionseinheit in Form eines Moduls für sich auszuwechseln. Es ist bei elektrischen Geräten generell bekannt (vgl. die DE-B- 1 302 591), eine Basisplatine mit Einsteckfassungen für eine Mehrzahl von Modul-Platinen vorzusehen.    Ausgehend von dem eingangs erläuterten Stand der Technik, liegt der Erfindung die Aufgabe zugrunde, eine für ein Autoradio ganz speziell angepaßte Konstruktion anzugeben, mit deren Hilfe bei dem Autoradio Störungen schnell und mit möglichst geringem Gesamtaufwand beseitigt werden können.

Das erfindungsgemäße Autoradio, bei dem die zuvor aufgezeigte Aufgabe gelöst ist, ist dadurch gekennzeichnet, daß die elektrischen und/oder elektronischen Bauelemente für jeweils eine Funktionseinheit des Autoradios, beispielsweise eine Senderabstimmung, einen Verstärker, einen Stereodecoder, einen Stereo/ Mono-Umschalter, einen Verkehrsfunkdecoder, einen Equalizer, auf jeweils einer Platine angeordnet sind, daß die Bedienungselemente und Anzeigelemente auf einer Bedienungs- und Anzeigeplatine angeordnet sind, daß eine Basisplatine mit Einsteckfassungen für die Platinen auf dem Boden des Gehäuses oder an dessen Decke angeordnet ist und daß durch Einstecken der Platinen von oben oder von unten in die Einsteckfassungen der Basisplatine die Platinen mechanisch mit der Basisplatine und damit miteinander und die elektrischen und/oder elektronischen Bauelemente verschiedener Platinen elektrisch miteinander verbindbar sind. Bei dem erfindungsgemäßen Autoradio wird also gewissermaßen ein modularer Aufbau verwirklicht. Damit wird von der Erkenntnis Gebrauch gemacht, daß auch bei Autoradios meist nur einzelne Funktionseinheiten gestört sind und daß das Auswechseln einer einzelnen Funktionseinheit schnell und problemlos möglich ist, wenn die jeweilige Funktionseinheit mechanisch und elektrisch zusammenhängend, also als Modul ausgebildet ist. Jede Funktionseinheit des Autoradios weist also eine Platine auf, auf der alle für diese Funktionseinheit notwendigen Bauelemente angeordnet sind. In spezieller Anpassung an die Veraussetzungen bei Autoradios gilt dies auch für die auf der Frontplatte des Gehäuses angeordneten Bedienungselemente und Anzeigeelemente, die hier auf einer Bedienungs- und Anzeigeplatine angeordnet sind. Die Frontplatte mit den Bedienungselementen und Anzeigeelementen bildet also mit der Bedienungs- und Anzeigeplatine eine Baueinheit - einen Modul -, wobei die Bedienungs- und Anzeigeplatine in erster Linie eine Übertragungs- und Anschlußfunktion übernimmt. Von besonderem Vorteil ist dies bei Verwendung von elektronischen Bedienungselementen und Anzeigeelementen anstelle der klassischen mechanischen Bedienungselemente und Anzeigeelemente, also beispielsweise bei Verwendung von Tipptastern, Leuchtdioden und Flüssigkristallanzeigen.

Die Platinen der verschiedenen Funktionseinheiten sind mechanisch und elektrisch mit der Basisplatine verbunden, wobei auch die Basisplatine eine Vielzahl von Leiterbahnen aufweist, über die die elektrischen Verbindungen zwischen den einzelnen Platinen hergestellt werden. Im Ergebnis werden für die elektrischen Verbindungen zwischen den verschiedenen elektrischen und/oder elektronischen Bauelementen bei dem erfindungsgemäßen Autoradio praktisch keine frei verlegten elektrischen Leitungen mehr benötigt. Alle elektrischen Verbindungen werden über die Leiterbahnen der Platinen und der Basisplatine hergestellt, wozu die Platinen in an sich bekannter Weise randseitig mit einem Einsteck- und Kontaktstreifen versehen sind, während die Einsteckfassungen an der Basisplatte in an sich bekannter Weise mit Kontaktzungen ausgestattet sind.

Von wesentlicher Bedeutung für die Erfindung ist nun, daß, abgesehen vom modularen Aufbau des beanspruchten Autoradios insgesamt, eine speziell für Autoradios angepaßte und geeignete Konstruktion verwirklicht worden ist. Durch die Anordnung der Bedienungselemente und Anzeigeelemente auf einer Bedienungs- und Anzeigeplatine, was insbesondere bei der Verwendung von Tipptastern, Leuchtdioden und Flüssigkristallanzeigen sehr einfach möglich ist, kann auch die Bedienungs- und Anzeigeplatine wie die anderen Platinen in die Basisplatine eingesteckt werden. Da die Lage der Bedienungselemente und Anzeigeelemente an der Frontplatte des Gehäuses vorgegeben ist, ist auch die Lage der Bedienungs- und Anzeigeplatine relativ zur Basisplatine vorgegeben. Das führt dazu, daß die Basisplatine auf dem Boden des Gehäuses angeordnet ist und daß die Platinen von oben her in die Einsteckfassungen der Basisplatine einsteckbar sind.

Eine Alternative für die Anordnung der Basisplatine ist dadurch gegeben, daß diese auch an der Decke des Gehäuses angeordnet sein kann, wobei dann die Platinen natürlich von unten in die Einsteckfassungen der Basisplatine einsteckbar sind. Diese Alternative trägt der Tatsache Rechnung, daß die meisten Autoradios in die Armaturenbretter von Autos eingebaut werden und daß der Raum hinter den Armaturenbrettern bei manchen Autos von unten her mehr oder weniger frei zugänglich ist. Unter diesen Voraussetzungen ist vielfach ein eingebautes Autoradio von unten her zugänglich. Durch die zuvor erläuterte Alternative der Erfindung wird die Möglichkeit geschaffen, die Platinen ggf. bei eingebautem Autoradio auswechseln zu können.

Die voranstehenden Ausführungen machen deutlich, daß mit dem erfindungsgemäßen Autoradio der zur Beseitigung von Störungen notwendige Gesamtaufwand in mehrfacher Hinsicht geringer ist als bei bekannten Autoradios. Das Innere des erfindungsgemäßen Autoradios ist wegen des modularen Aufbaus aufgeräumt, leicht überschaubar und leicht zugänglich. Es besteht die Möglichkeit, die gestörte Funktionseinheit insgesamt auszuwechseln, indem einfach die gesamte Platine mit allen darauf befindlichen elektrischen und/oder elektronischen Bauelementen ausgewechselt wird. Durch die Verkürzung der Arbeitszeit für Reparaturen an dem Autoradio tritt eine erhebliche Minderung der Reparaturkosten ein. Die Minderung der Reparaturkosten wird nicht durch erhöhte Teilekosten ausgeglichen, da die wegen einer Störung ausgewechselte Funktionseinheit nicht weggeworfen werden muß, sondern in der Werkstatt in Ruhe instandgesetzt werden kann. Die Vereinfachung bei Reparaturen bringt den zusätzlichen Vorteil, daß die Reparaturen soweit der Kunde betroffen ist, unmittelbar durchgeführt werden können. Der Kunde kann also vielfach auf sein Fahrzeug warten, ein Ersatzgerät muß nicht gestellt und eingebaut werden, ein zweimaliges Anfahren der Werkstatt in Verbindung mit einer Reparatur des Autoradios ist nicht mehr notwendig.

Zweckmäßig ist es, das Gehäuse mit einem abnehmbaren Deckel zu versehen. Der abnehmbare Deckel ist bei auf dem Boden des Gehäuses angeordneter Basisplatine zweckmäßigerweise auf der Oberseite des Gehäuses vorgesehen, während er bei an der Decke des Gehäuses angeordneter Basisplatine zweckmäßigerweise auf der Unterseite des Gehäuses vorgesehen ist. In beiden Fällen ist also das Innere des Gehäuses von der der Basisplatine gegenüber liegenden Seite her zugänglich.

Ist das Gehäuse mit einem abnehmbaren Deckel versehen, so empfiehlt es sich, den Deckel an seiner Innenseite mit Haltausformungen für die Platinen zu versehen. Die Halteausformungen an der Innenseite des Deckels halten die Platinen in ihrer Einbaulage fest und verhindern insbesondere, daß sich die Platinen durch Rüttelbewegungen aus ihren Einsteckfassungen lösen.

Zuvor ist erläutert worden, daß bei entsprechender Ausgestaltung des erfindungsgemäßen Autoradios die Platinen der Funktionseinheiten sogar bei eingebautem Autoradio ausgewechselt werden können. In diesem Zusammenhang besteht eine weitere Möglichkeit darin, das erfindungsgemäß Autoradio so auszugestalten, daß die Basisplatine gemeinsam mit den Platinen nach vorn aus dem Gehäuse herausziehbar ist. Damit ist dann die Frontplatte gemeinsam mit der Bedienungs- und Anzeigeplatine und gemeinsam mit der Basisplatine und mit den mit der Basisplatine verbundenen weiteren Platinen nach vorn aus dem Gehäuse herausziehbar. Besonders in diesem Fall ist es dann zweckmäßig, wenn an den Seitenwänden des Gehäuses Führungs- und Halteleisten für die Basisplatine und ggf. die Platinen vorgesehen sind. Die Führungs- und Halteleisten dienen gewissermaßen als Einschubschienen für die Basisplatine, über die die Basisplatine gleichzeitig mit dem Gehäuse des Autoradios verbunden ist.

Insbesondere, jedoch nicht ausschließlich bei der zuletzt erläuterten Ausführungsform eines erfindungsgemäßen Autoradios kann, beispielsweise an der Rückwand des Gehäuses, eine gesonderte Einsteckfassung für die Basisplatine vorgesehen sein, über die die externen Anschlüsse an die Versorgungsspannung, die Antenne und die Lautsprecher hergestellt werden.

Im folgenden wird die Erfindung anhand einer lediglich ein Ausführungsbeispiel darstellenden Zeichnung näher erläutert; es zeigt

Fig. 1 in schematischer Darstellung, teilweise geöffnet, ein Ausführungsbeispiel eines erfindungsgemäßen Autoradios,

Fig. 2 den Gegenstand nach Fig. 1 in Draufsicht und

Fig. 3 einen Schnitt durch den Gegenstand nach Fig. 2 entlang der Linie III-III.

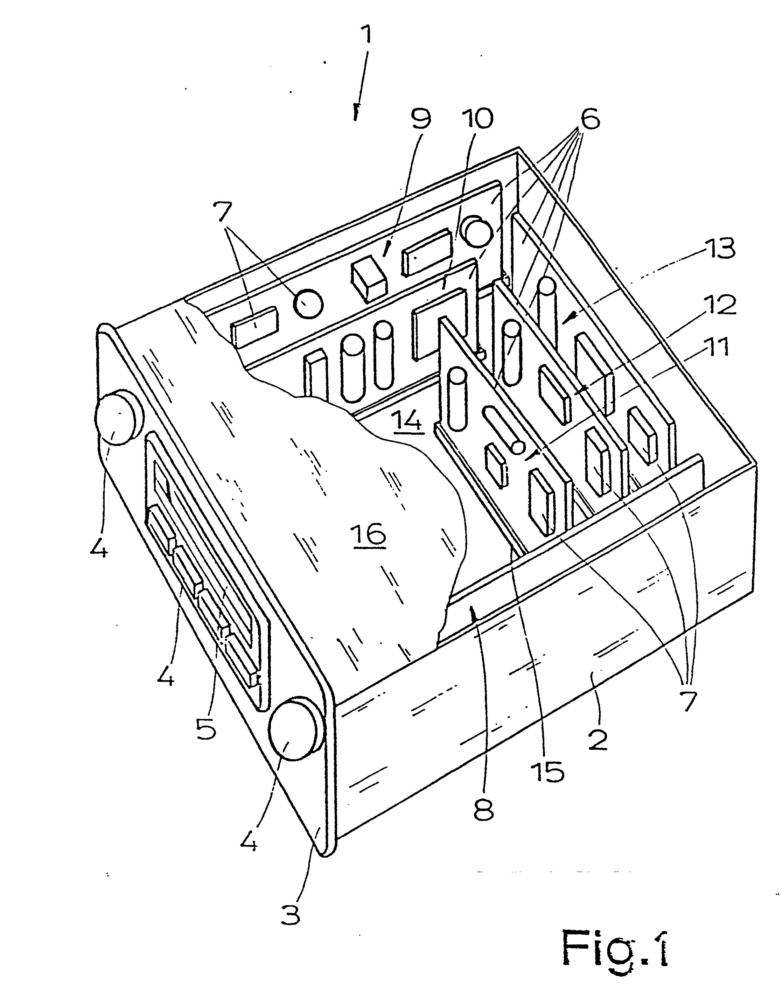

In den Fig. 1 bis 3 ist ein Autoradio 1 dargestellt, das ein Gehäuse 2, mehrere auf einer Frontplatte 3 des Gehäuses 2 angeordnete Bedienungselemente 4 und Anzeigeelemente 5 und mehrere in dem Gehäuse 2 angeordnete Platinen 6 aufweist. Auf den Platinen 6 im Gehäuse 2 des Autoradios 1 sind jeweils mehrere elektrische und/oder elektronische Bauelemente 7 angeordnet. Die Bauelemente 7 auf verschiedenen Platine 6 sind elektrisch miteinander verbunden.

Die elektrischen und/oder elektronischen Bauelemente 7 für jeweils eine Funktionseinheit des Autoradios 1, nämlich für eine Senderabstimmung 8, einen Verstärker 9, einen Stereodecoder 10, einen Stereo/Mono-Umschalter 11, einen Verkehrsfunkdecoder 12 und einen Equalizer 13, sind auf jeweils einer Platine 6 angeordnet. Außerdem ist eine Basisplatine 14 mit Einsteckfassungen 15 für die Platinen 6 vorgesehen. Die Platinen 6 sind durch Einstecken in die Einsteckfassungen 15 der Basisplatine 14 mechanisch mit der Basisplatine 14 und damit miteinander verbunden. Durch das Einstecken der Platinen 6 in die Einsteckfassungen 15 der Basisplatine 14 sind gleichzeitig die elektrischen und/oder elektronischen Bauelemente 7 verschiedener Platinen 6 auch elektrisch miteinander verbunden.

In den Figuren nicht zu erkennen ist, daß die auf der Frontplatte 3 des Gehäuses 2 angeordneten Bedienungselemente 4 und Anzeigeelemente 5 auf einer eigenen Bedienungs- und Anzeigeplatine angeordnet sind und daß auch die Bedienungs- und Anzeigeplatine in eine Einsteckfassung der Basisplatine 14 eingesteckt ist.

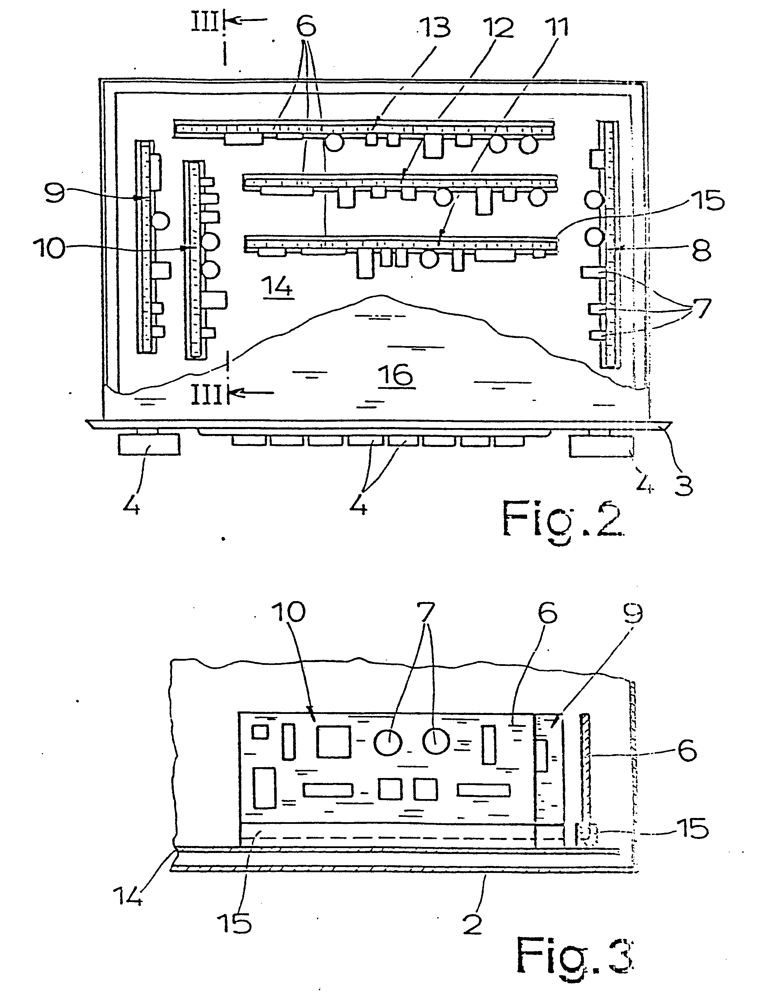

Aus Fig. 1 ist zu erkennen, daß die Basisplatine 14 bei dem dargestellten Ausführungsbeispiel eines Autoradios 1 auf dem Boden des Gehäuses 2 angeordnet ist und daß die Platinen 6 von oben in die Einsteckfassungen 15 der Basisplatine 14 eingesteckt sind. Im übrigen zeigen die Fig. 1 und 2, daß das Gehäuse 2 auf seiner Oberseite mit einem abnehmbaren Deckel 16 versehen ist.

Fig. 3 zeigt nochmals die Einsteckfassungen 15 an der Basisplatine 14. Aus dieser Darstellung wird deutlich, wie einfach die Platinen 6 nach oben aus den Einsteckfassungen 15 an der Basisplatine 14 herausgezogen werden können, wie einfach also ein Auswechseln der entsprechenden Funktionseinheiten des Autoradios 1 möglich ist.

## Patentansprüche

1. Autoradio mit einem Gehäuse, mehreren auf einer Frontplatte des Gehäuses angeordneten Bedienungselementen und Anzeigeelementen und mehreren in dem Gehäuse angeordneten Platinen, wobei auf den Platinen jeweils mehrere elektrische und/oder elektronische Bauelemente angeordnet sind und wobei elektrische und/oder elektronische Bauelemente auf verschiedenen Platinen elektrisch miteinander verbunden sind, dadurch gekennzeichnet, daß die elektrischen und/oder elektronischen Bauelemente (7) für jeweils eine Funktionseinheit des Autoradios (1), beispielsweise eine Senderabstimmung (8), einen Verstärker (9), einen Stereodecoder (10), einen Stereo/Mono-Umschalter (11), einen Verkehrsfunkdecoder (12), einen Equalizer (13), auf jeweils einer Platine (6) angeordnet sind, daß die Bedienungselemente (4) und Anzeigeelemente (5) auf einer Bedienungs- und Anzeigeplatine angeordnet sind, daß eine Basisplatine (14) mit Einsteckfassungen (15) für die Platinen (6) auf dem Boden des Gehäuses (2) oder an dessen Decke angeordnet ist und daß durch Einstecken der Platinen (6) von oben oder von unten in die Einsteckfassungen (15) der Basisplatine (14) die Platinen (6) mechanisch mit der Basisplatine (14) und damit miteinander und die elektrischen und/oder elektronischen Bauelemente (7) verschiedener Platinen (6) elektrisch miteinander verbindbar sind.

2. Autoradio nach Anspruch 1, dadurch gekennzeichnet, daß das Gehäuse (2) auf seiner Oberseite oder seiner Unterseite mit einem abnehmbaren Deckel (16) versehen ist.

3. Autoradio nach Anspruch 2, dadurch gekennzeichnet, daß der Deckel an seiner Innenseite mit Halteausformungen für die Platinen versehen ist.

4. Autoradio nach einem der Ansprüche 1 bis 3, dadurch gekennzeichnet, daß die Basisplatine gemeinsam mit den Platinen nach vorn aus dem Gehäuse herausziehbar ist.

5. Autoradio nach einem der Ansprüche 1 bis 4, dadurch gekennzeichnet, daß an dem Boden, der Decke und/oder den Seitenwänden des Gehäuses Führungs- und Halteleisten für die Basisplatine und/oder die Platinen vorgesehen sind.

6. Autoradio nach einem der Ansprüche 1 bis 5, dadurch gekennzeichnet, daß am Gehäuse eine mit der Versorgungsspannung, der Antenne und/oder den Lautsprechern verbundene Einsteckfassung für die Basisplatine vorgesehen ist.

## Claims

1. Car radio having a housing, several controls and indicators disposed on a front plate of the housing and several circuit boards disposed in the housing, with several electric and/or electronic structural members disposed on each of the boards and with electric and/or electronic structural elements being electrically connected to one another on different boards, characterised in that the electric and/or electronic structural elements (7) for any one functional unit of the car radio (1), for example a station tuner (8), an amplifier (9), a stereo decoder (10), a stereo/mono selector switch (11), a traffic radio decoder (12), an equalizer (13), are each disposed on one board (6),
in that the controls (4) and indicators (5) are disposed on a control and indicator board, in that a base board (14) having plug-in sockets (15) for the boards (6) is disposed on the base of the housing (2) or is disposed on its cover and
in that by inserting the boards (6) from above or from below into the plug-in sockets (15) of the base board (14) the boards (6) can be connected mechanically to the base board (14) and consequently to one another and the electric and/or electronic structural elements (7) of different boards (6) can be electrically connected to one another.

2. Car radio according to Claim 1, characterised in that the housing (2) is provided with a removable cover (16) on its upper or lower surface.

3. Car radio according to Claim 2, characterised in that the cover is provided with mounts for the boards.

4. Car radio according to one of Claims 1 to 3, characterised in that the base board together with the boards can be withdrawn in the forward direction from the housing.

5. Car radio according to one of Claims 1 to 4, characterised in that guide and retaining strips for the base board and/or the boards are provided on the floor, top and/or side walls of the housing.

6. Car radio according to one of Claims 1 to 5, characterised in that a plug-in socket for the base board connected to the supply voltage, the antenna and/or the loud speakers is provided on the housing.

## Revendications

1. Poste de radio pour automobile, comportant un boîtier, plusieurs élements de commande et éléments indicateurs disposés sur une plaque frontale du boîtier, et plusieurs platines disposées dans le boîtier, dans lequel plusieurs composants électriques et/ou électroniques sont disposés sur chacune des platines et dans lequel des composants électriques et/ou électroniques situés sur différentes platines sont connectés électriquement les uns aux autres, caractérisé en ce que les composants électriques et/ou électroniques (7) prévus pour un bloc fonctionnel respectif du poste de radio (1), par exemple un bloc d'accord (8), un amplificateur (9), un décodeur stéréo (10), un commutateur stéréo/mono (11), un décodeur de messages routiers (12), un égaliseur (13), sont disposés sur une platine (6) respective, en ce que les éléments de commande (4) et les éléments indicateurs (5) sont disposés sur une platine de commande et d'indication, en ce qu'une platine de base (14) pourvue de montures à emboîtement (15) pour les platines (6) est disposée au fond ou au sommet du boîtier (2), et en ce que, par emboîtement des platines (6) par le haut ou par le bas dans les montures à emboîtement (15) de la platine de base (14), d'une part les platines (6) sont connectées mécaniquement à la platine de base (14) et par conséquent les unes aux autres, et d'autre part les composants électriques et/ou électroniques (7) de différentes platines (6) sont connectés électriquement les uns aux autres.

2. Poste de radio selon la revendication 1, caractérisé en ce que le boîtier (2) est pourvu d'un couvercle amovible (16) sur sa face supérieure ou sur sa face inférieure.

3. Poste de radio selon la revendication 2, caracterise en ce que le couvercle comporte sur son côté intérieur des organes de maintien des platines.

4. Poste de radio selon l'une des revendications 1 à 3, caractérisé en ce que la platine de base est agencée pour être extraite du boîtier avec l'ensemble des platines.

5. Poste de radio selon l'une des revendications 1 à 4, caractérisé en ce que des profils de guidage et de maintien de la platine de base et/ou des platines sont prévus sur le fond, le couvercle et/ou les parois latérales du boîtier.

6. Poste de radio selon l'une des revendications 1 à 5, caractérisé en ce que le boîtier comporte, pour la platine de base, une monture à emboîtement qui est connectée à la source d'alimentation, à l'antenne et/ou aux hauts-parleurs.

Fig.1

Fig.2

Fig.3